# EUROPEAN PATENT APPLICATION

(11) **EP 4 647 785 A1**
(43) Date of publication of application: **12.11.2025**
(21) Application number: 24900772.5
(22) Date of filing: 11.07.2024
(51) Int. Cl.: G01R 31/367, G01R 31/36, G01R 31/389, G01R 31/385, G01R 31/392, G01R 31/382, G01R 31/396, G06T 7/00, H01M 10/052

(54) **SERVER AND BATTERY ANALYSIS METHOD THEREOF**

(30) Priority: 05.12.2023 KR 20230174544; 05.12.2023 KR 20230174550
(71) Applicant: LG Energy Solution, Ltd., Seoul 07335 (KR)
(72) Inventor: KYUNG, Wonshik, Daejeon 34122 (KR); LEE, Eun Ju, Daejeon 34122 (KR); RAH, Kyun Il, Daejeon 34122 (KR); SON, Kihyun, Daejeon 34122 (KR)
(74) Representative: Goddar, Heinz J.
(86) International application number: PCT/KR2024/009968
(87) International publication number: WO 2025/121583

(57) **Abstract**

Provided is a battery analysis method performed on a server, the method comprising the steps of: acquiring electrochemical impedance spectroscopy (EIS) information for each of a plurality of different states of charge, the EIS information being confirmed by performing EIS on a battery cell in the plurality of states of charge; generating distribution of relaxation times (DRT) information for each of the plurality of states of charge by calculating a DRT for the EIS information for each of the plurality of states of charge; and generating, on the basis of the DRT information for each of the plurality of states of charge, a feature image corresponding to the battery cell, the feature image including magnitude information about impedance according to frequency, the magnitude information being calculated for each of the plurality of states of charge.

## Description

### Technical Field

This application claims the benefit of Korean Patent Application Nos. 10-2023-0174550, filed on December 5, 2023, and 10-2023-0174544, filed on December 5, 2023 in the Korean Intellectual Property Office, the disclosures of which are incorporated herein by reference.

The present disclosure relates to a battery analysis method and a server performing the same.

### Background Art

One of various technologies in the related art used to analyze a battery cell is electrochemical impedance spectroscopy (EIS). The EIS is an analysis method of applying an alternating current voltage or an alternating current in various frequencies, calculating impedance based on an alternating current or and alternating voltage measured as a result of the applying, and showing the impedance in a Nyquist plot and has been widely used in that the battery cell may be analyzed in a non-destructive manner.

One of technologies in the related art used to further easily analyze a result of the EIS is distribution of relaxation times (DRT). The DRT is widely used in that impedance data calculated as a result of the EIS may be converted into a distribution of relaxation times so that an equivalent circuit of a battery may be identified while preliminary knowledge for impedance of the battery is not required.

Meanwhile, a result of analyzing the battery acquired as a result of the EIS and the DRT still shows a relatively limited characteristic of the battery. Accordingly, an analysis method for analyzing further various characteristics of the battery is currently required.

### Detailed Description of the Invention

### Technical Goals

Example embodiments of the present disclosure are to provide an analysis method for a battery and a server performing the same. Specifically, a method of analyzing further various characteristics of the battery based on a result of EIS and DRT is to be provided. In addition, a method of drawing the further various characteristics of the battery by analyzing a characteristic image of a battery cell, which is acquired based on the result of EIS and DRT, is to be provided.

However, the goals to be achieved by example embodiments of the present disclosure are not limited to the objectives described above and other objects may be clearly understood from the following example embodiments.

### Technical solutions

According to an aspect of the present disclosure, there is provided a battery analysis method performed in a server, the battery analysis method including acquiring electrochemical impedance spectroscopy (EIS) information for each of a plurality of states of charge, which is identified by performing electrochemical impedance spectroscopy for a battery cell at the plurality of states of charge which are different from each other, generating distribution of relaxation times (DRT) information for each of the plurality of states of charge by calculating a distribution of relaxation times for the EIS information for each of the plurality of states of charge, and generating, based on the DRT information for each of the plurality of states of charge, a characteristic image that corresponds to the battery cell and includes magnitude information on impedance according to a frequency, which is calculated for each of the plurality of states of charge.

The generating of the characteristic image may include generating, based on the DRT information for each of the plurality of states of charge, the characteristic image which has a form of a two-dimensional image of which a first axis is the frequency, a second axis is the states of charge, and a shade degree of each pixel is determined based on the magnitude information on the impedance which is calculated for each of the frequency and the plurality of states of charge.

The generating of the characteristic image may include generating a first characteristic image for a charging process of the battery cell, which is at least a portion of the characteristic image, based on first magnitude information on the impedance according to the frequency for each of the plurality of states of charge for the charging process, with identifying the first magnitude information based on first DRT information for each of the plurality of states of charge in the charging process, and generating a second characteristic image for a discharging process of the battery cell, which at least a portion of the characteristic image, based on second magnitude information on the impedance according to the frequency for each of the plurality of states of charge for the discharging process, with identifying the second magnitude information based on second DRT information for each of the plurality of states of charge in the discharging process.

The characteristic image may include the first characteristic image and the second characteristic image so that the first characteristic image and the second characteristic image are symmetrical around a reference axis parallel to the first axis.

The battery analysis method may further include storing a characteristic image set for a plurality of reference battery cells, which includes the characteristic image.

The characteristic image set may be stored in association with at least a portion of reference characteristic information including at least a portion of material information, degradation degree information, and utilization environment information on each of the reference battery cells which correspond to respective images included in the character image set.

The battery analysis method may further include generating a target image for a target battery cell based on target DRT information, with acquiring the target DRT information by calculating the DRT for target EIS information, after acquiring a plurality of pieces of target EIS information by performing the EIS at a plurality of states of charge different from each other of the target battery cell, and estimating characteristic information on the target battery cell based on the characteristic image set and the target image.

The estimating of the characteristic information on the target battery cell may include estimating, after calculating similarities between the target image and images included in the characteristic image set, reference characteristic information associated with an image having a highest similarity among the similarities to be the characteristic information on the target battery cell.

The estimating of the characteristic information on the target battery cell may include estimating, by inputting the target image to an artificial neural network trained by receiving the characteristic image set and reference characteristic information corresponding to each image included in the characteristic image set as learning data and ground-truth for the learning data, characteristic information that is output as the artificial neural network processes the target image to be the characteristic information on the target battery cell.

The acquiring of the electrochemical impedance spectroscopy (EIS) information for each of the plurality of states of charge may include acquiring first EIS information that is at least a portion of the EIS information, which is a result of the EIS being performed for the battery cell by a battery management device each time a state of charge of the battery cell is increased by a predetermined interval in a charging process that allows the battery cell at a first state of charge to be at a second state of charge higher than the first state of charge, and acquiring second EIS information that is at least a portion of the EIS information, which is a result of the EIS being performed for the battery cell by the battery management device each time the state of charge of the battery cell is decreased by a predetermined interval in a discharging process that allows the battery cell at the second state of charge to be at the first state of charge.

The generating of the DRT information may include generating first DRT information for each of the plurality of states for a charging process of the battery cell, which is at least a portion of the DRT information, by calculating the DRT for first EIS information for each of the plurality of states of charge in the charging process, and generating second DRT information for each of the plurality of states for a discharging process of the battery cell, which is at least a portion of the DRT information, by calculating the DRT for second EIS information for each of the plurality of states of charge in the discharging process.

The battery analysis method may further include estimating at least a portion of characteristic information including at least a portion of material information, degradation degree information, and utilization environment information on the battery cell by performing an analysis based on the characteristic image.

The estimating of the at least a portion of the characteristic information may include determining symmetry between a first characteristic image corresponding to a charging process of the battery cell and a second characteristic image corresponding to a discharging process of the battery cell that are included the characteristic image, and estimating at least a portion of the material information on the battery cell based on the symmetry.

The determining of the symmetry may include calculating a similarity between the first characteristic image and the second characteristic image, and determining, based on the similarity which is less than a threshold, that the symmetry between the first characteristic image and the second characteristic image is absent.

The estimating of the at least a portion of the material information on the battery cell may include determining, based on the first characteristic image and the second characteristic image which do not have the symmetry, that at least a portion of an anode of the battery cell includes silicon oxide.

The estimating of the at least a portion of the material information on the battery cell may include estimating a ratio of the included silicon oxide to be in inverse proportion to a similarity between the first characteristic image and the second characteristic image, which corresponds to the symmetry.

The estimating of the at least a portion of the characteristic information on the battery cell may include extracting a shape pattern according to a shade on the characteristic image by calculating the characteristic image, and estimating at least a portion of the utilization environment information on the battery cell based on the shape pattern.

The estimating of the at least a portion of the characteristic information on the battery cell may include acquiring shade amount information on the characteristic image by calculating the characteristic image, and estimating the degradation degree information on battery cell based on the shade amount information.

According to another aspect of the present disclosure, there is also provided a sever including a memory configured to store an instruction, and a processor connected to the memory, and the processor is configured to acquire electrochemical impedance spectroscopy (EIS) information for each of a plurality of states of charge, which is identified by performing electrochemical impedance spectroscopy for a battery cell at the plurality of states of charge which are different from each other, generate distribution of relaxation times (DRT) information for each of the plurality of states of charge by calculating a distribution of relaxation times for the EIS information for each of the plurality of states of charge, and generate, based on the DRT information for each of the plurality of states of charge, a characteristic image that corresponds to the battery cell and includes magnitude information on impedance according to a frequency, which is calculated for each of the plurality of states of charge.

According to still another aspect of the present disclosure, there is also provided a non-transitory computer-readable recording medium in which a program for executing the above-described battery analysis method in a server is recorded.

Specific details of other embodiments are included in the detailed description and drawings.

### Effects of the Invention

According to proposed example embodiments, one or more of the following effects may be expected.

According to example embodiments of the present disclosure, it is possible to generate a characteristic image based on a result of EIS and DRT for each state of charge of a battery cell.

According to example embodiments of the present disclosure, it it possible to analyze a characteristic of a target battery cell based on a characteristic image set including respective characteristic images of each battery cell having respective characteristics.

According to example embodiments of the present disclosure, it is possible to analyze at least a portion of material information, degradation information, and utilization environment information on the target battery cell based on the characteristic image set.

According to example embodiments of the present disclosure, it is possible to identify, in a non-destructive manner, whether silicon oxide is included in an anode of the battery cell by analyzing the characteristic image.

According to example embodiments of the present disclosure, it is possible to analyze at least a portion of degradation information and utilization environment information on the battery cell based on a shape pattern of the characteristic image or shade amount information on the characteristic image.

Effects of the present disclosure are not limited to those described above and other effects may be made apparent to those skilled in the art from the following description of the accompanying claims.

### Brief Description of Drawings

FIG. 1 illustrates an interlocking relationship of a sever analyzing a battery according to an example embodiment.
FIG. 2 is a flowchart illustrating a battery analysis method according to an example embodiment.
FIGS. 3A and 3B illustrate an example of EIS information and DRT information in which a DRT is calculated therefor.
FIG. 4 is an example diagram illustrating a characteristic image generated by a battery analysis method according to an example embodiment.
FIGS. 5A and 5B are diagrams for describing a relationship between a characteristic image and DRT information according to an example embodiment.
FIG. 6 is an example diagram illustrating a characteristic image corresponding to a battery cell including silicon oxide in an anode according to an example embodiment.
FIG. 7 is a block diagram illustrating a server according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or "all of a, b, and c'.

In the present disclosure, a "terminal" may be implemented as a computer or a portable terminal capable of accessing a server or another apparatus through a network. The computer may include, for example, a laptop computer, a desktop computer, and a notebook equipped with a web browser. The portable apparatus may be a wireless communication device ensuring a portability and a mobility, and include any type of handheld wireless communication device, for example, a tablet PC, a smartphone, a communication-based apparatus such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

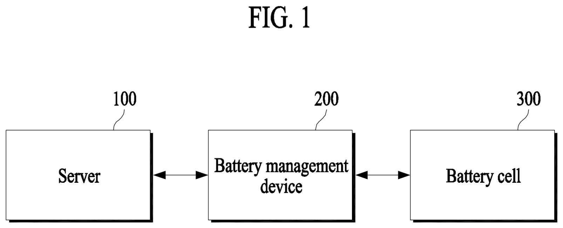

FIG. 1 illustrates an interlocking relationship of a sever analyzing a battery according to an example embodiment.

Referring to FIG. 1, a server 100 may be interlocked with a battery management device 200 managing a battery cell 300 and operate. Meanwhile, only elements associated with the present example embodiment are illustrated in FIG. 1. Thus, those skilled in the art associated with the present example embodiment may understand that other elements in general use in addition to the elements illustrated in FIG. 1 may be further included.

The server 100 is a device that configures and provides a variety of information. The sever 100 may provide the configured information in a web page, an application screen, or the like or may provide the configured information in a form displayable in the web page, on an application screen, or the like in a received terminal.

The battery management device 200 may include one or more sensors for measuring a parameter such as an electric current, a voltage, or a temperature of the battery cell 300 and include a memory and a processor (not illustrated) for various operations. In other words, the above-described batter management device 200 may operate based on the memory and the processor similarly to the sever 100, but may additionally include a sensor to measure and calculate a parameter of the battery cell 300. According to an example embodiment, the battery management device 200 may apply an external alternating current power source, namely, an alternating current voltage or an alternating current to the battery cell 300 in various frequencies and measure an electric current or voltage flowing according thereto. Through this, the battery management device 200 may perform electrochemical impedance spectroscopy (EIS). In addition, such EIS may be performed at intervals of a predetermined state of charge, at intervals of a designated plurality of states of charge, or at intervals of random states of charge while a battery is charged or discharged. For example, when the EIS is performed at the intervals of the predetermined state of charge, the EIS may be performed each time a state of charge (SoC) is increased by 1 percent (%) until the SoC reaches 99% from 1%, and the EIS may be performed each time the SoC is decreased by 1% until reaching 1% from 99% during discharging. As such, the battery management device 200 may interlock and perform charging and discharging processes and the EIS.

Here, the server 100 and the battery management device 200 each may be a completely separated and independent object. However, the server 100 and the battery management device 200 may be only conceptually separated to exist in one device or system. That is, one computing device having a control function for the battery cell may perform all functions of the server 100 and the battery management device 200 that will be described below, and accordingly, such an example embodiment is regarded as being included in the scope of the present disclosure.

The battery cell 300 may be one of various secondary batteries. For example, the battery cell 300 may be not only a widely used conventional secondary battery such as a lithium-ion battery but also one of various next generation secondary batteries such as a lithium-sulfur battery, a lithium metal battery, an all-solid-state battery, a metal-air battery, an aluminum-ion battery, a potassium-ion battery, or a zinc-air battery. According to an example embodiment, as described below, the battery cell 300, as a lithium-ion battery, may include or not include silicon oxide in an anode. Also, according to an example embodiment, a battery analysis method of the present disclosure may be performed for determining whether the silicon oxide is included in the anode of the lithium-ion battery. Undoubtedly, a configuration in which the battery cell 300 is the lithium-ion battery and whether the silicon oxide is included in the anode is determined through the analysis method of the present disclosure is merely an example. In other words, the battery cell 300 may be a secondary battery of various types, and material information on a cathode or an electrolyte, whether an element other than the silicon oxide is included in the anode, utilization environment information on the battery, or degradation degree information on the battery may be identified through the analysis method of the present disclosure, which will be described below.

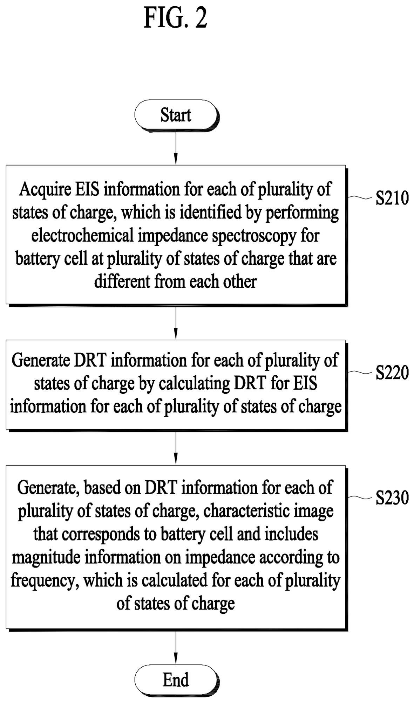

Hereinafter, the battery analysis method according to an example embodiment of the present disclosure will be described with reference to FIG. 2.

FIG. 2 is a flowchart illustrating a battery analysis method according to an example embodiment.

Referring to FIG. 2, in operation S210, the server 100 may acquire EIS information for each of a plurality of states of charge, which is identified by performing EIS for the battery cell 300 at the plurality of states of charge which are different from each other. In operation S220, the server 100 may generate distribution of relaxation times (DRT) information for each of the plurality of states of charge by calculating a DRT for the EIS information for each of the plurality of states of charge. In operation S230, the sever 100 may generate, based on the DRT information for each of the plurality of states of charge, a characteristic image that corresponds to the battery cell 300 and includes magnitude information on impedance according to a frequency, which is calculated for each of the plurality of states of charge.

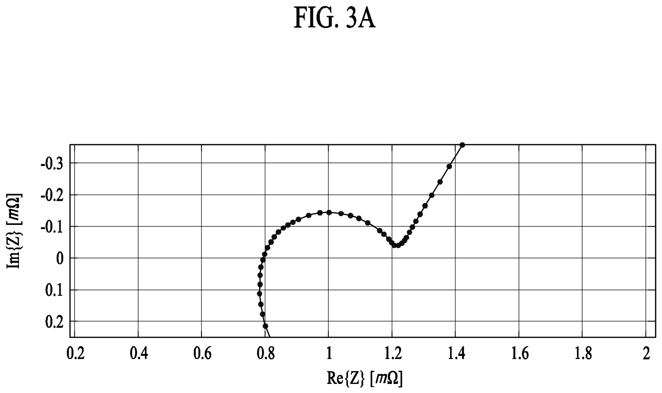

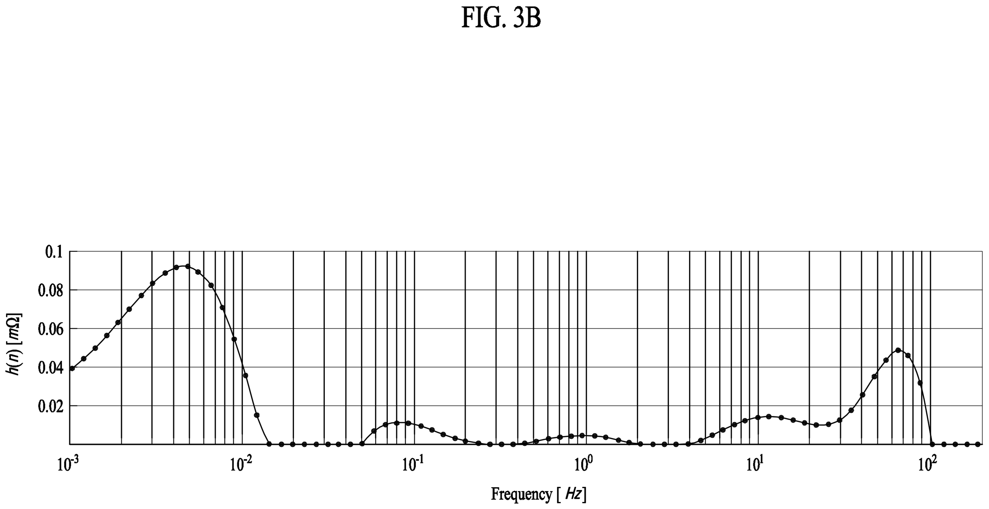

Hereinafter, the EIS information and the DRT information will be described with reference to FIG. 3 for easier understanding of the present disclosure.

FIGS. 3A and 3B illustrate an example of EIS information and DRT information in which a DRT is calculated therefor. Referring to FIG. 3A, when EIS is performed for a battery cell, the EIS information may be identified in a Nyquist plot in which a magnitude of impedance for each frequency is divided and shown in a real part and a imaginary part. In addition, when the DRT is calculated based on the Nyquist plot drawn as illustrated in FIG. 3A, the magnitude of the impedance for each logarithmically scaled frequency may be drawn to be the DRT information as illustrated in FIG. 3B.

EIS analysis or EIS measurement disclosed in the present disclosure may be a process of performing the electrochemical impedance spectroscopy for the battery cell, and the EIS information or EIS data may be information showing an impedance value according to a frequency for the battery cell. The EIS information may be impedance information that may be shown in a Nyquist plot. DRT analysis disclosed in the present disclosure may be an analysis technique for identifying an impedance value according to each frequency for the EIS information, and the DRT information may be a distribution graph in which the impedance information is converted into a distribution for relaxation times. In other words, the DRT information may be a graph showing a distribution of impedance values by frequency.

Hereinafter, each operation will be described in further detail.

To begin with, the server 100 may acquire the EIS information for each of a plurality of states of charge for the battery cell 300. Here, such EIS information may be acquired from the battery management device 200. As described above, while charging and discharging the battery cell 300, the battery management device 200 may measure the EIS information by performing the EIS at each of the plurality of states of charge which are which are different from each other. For example, the battery management device 200 may perform the EIS at each of states of charge arranged at a predetermined interval or at designated states of charge. The server 100 may acquire such EIS information from the battery management device 200.

According to an example embodiment, the EIS information may include first EIS information that is a result of the EIS being performed for the battery cell 300 at the plurality of states of charge different from each other when a state of charge of the battery cell 300 is increased in a charging process that allows the battery cell 300 at a first state of charge to be at a second state of charge higher than the first state of charge and second EIS information that is a result of the EIS being performed for the battery cell 300 at the plurality of states of charge different from each other when the state of charge of the battery cell 300 is decreased in a discharging process that allows the battery cell 300 at the second state of charge to be at the first state of charge. That is, the battery management device 200 may measure the first EIS information in the charging process and the second EIS information in the discharging process, and the server 100 may acquire the EIS information including the first EIS information and the second EIS information from the battery management device 200. As described above, in the charging process and the discharging process, the EIS may be performed each time the state of charge is increased or decreased by a predetermined interval, performed at each of a predetermined plurality of states of charge, or performed at each of random states of charge.

Afterward, the server 100 may generate the DRT information for each of the plurality of states of charge by calculating the DRT for the EIS information acquired as such. At this point, first DRT information and second DRT information may be respectively generated for the first EIS information and the second EIS information which respectively correspond to the charging process and the discharging process. Specifically, the server 100 may generate the first DRT information for each of the plurality of states for the charging process, which is at least a portion of the DRT information, by calculating the DRT for the first EIS information for each of the plurality of states of charge in the charging process. In addition, the server 100 may generate the second DRT information for each of the plurality of states for the charging process, which is at least a portion of the DRT information, by calculating the DRT for the second EIS information for each of the plurality of states of charge in the discharging process.

Afterward, the sever 100 may generate, based on the DRT information for each of the plurality of states of charge, a characteristic image that corresponds to the battery cell and includes magnitude information on impedance according to the frequency, which is calculated for each of the plurality of states of charge. Here, the characteristic image may have a form of a two-dimensional image of which a first axis is the frequency, a second axis is the states of charge, and a shade degree of each pixel is determined based on the magnitude information on the impedance calculated for each of the frequency and the plurality of states of charge.

Here, the magnitude information on the impedance may be shown as the shade degree of each pixel as described above, but may be shown as a height above a three-dimensional image. In other words, in this case, the characteristic image may have a three-dimensional shape and be generated by showing, as the magnitude information on the impedance, a value of a third axis perpendicular to a plane of which a first axis is the frequency and a second axis is the state of charge.

According to an example embodiment, the server 100 may generate a first characteristic image and a second characteristic image by calculating each of the first DRT information which corresponds to the charging process and the second DRT information which corresponds to the discharging process. Specifically, the server 100 may identify first magnitude information on the impedance according to the frequency for each of the plurality of states of charge for the charging process of the battery cell 300 based on the first DRT information for each of the plurality of states of charge in the charging process and generate the first characteristic image for the charging process, which is at least a portion of the characteristic image, based on the first magnitude information. Also, the server 100 may identify second magnitude information on the impedance according to the frequency for each of the plurality of states of charge for the discharging process of the battery cell 300 based on the second DRT information for each of the plurality of states of charge in the charging process and generate the second characteristic image for the discharging process, which is at least a portion of the characteristic image, based on the second magnitude information.

According to an example embodiment, the characteristic image may include the first characteristic image and the second characteristic image so that the first characteristic image and the second characteristic image are symmetrical around a reference axis parallel to the first axis. That is, the characteristic image may be generated so as to easily identify a magnitude of impedance, which is shown in a shade for the charging process and the discharging process, for an equal frequency.

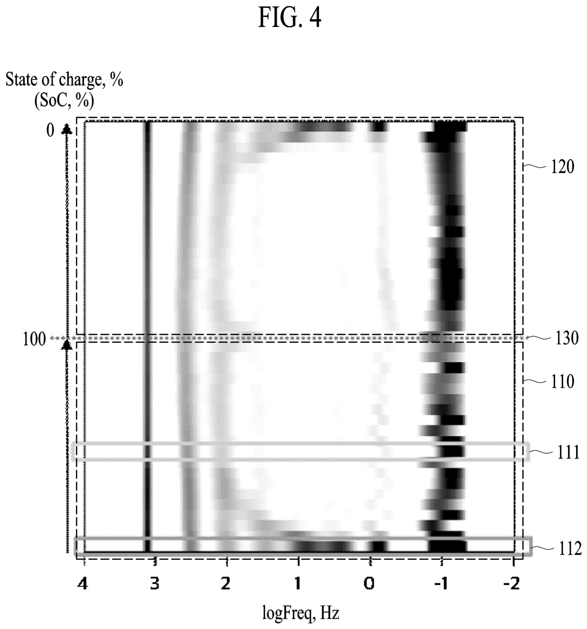

FIG. 4 will be referenced in order to check an example of the characteristic image generated as such.

FIG. 4 is an example diagram illustrating a characteristic image generated by a battery analysis method according to an example embodiment.

Referring to FIG. 4, the characteristic image may include a structure in which a first characteristic image 110 and a second characteristic image 120 are symmetrical around a reference axis 130. However, such a structure is merely an example. The characteristic image may include the first characteristic image 110 and the second characteristic image 120 with another scheme, for example, so that the first characteristic image 110 and the second characteristic image 120 are symmetrical around a reference axis parallel to a second axis. In addition, the characteristic image may include the first characteristic image 110 and the second characteristic image 120 in an asymmetrical structure. Example embodiments of generating characteristic images according to such various aspects may be all included in the present disclosure.

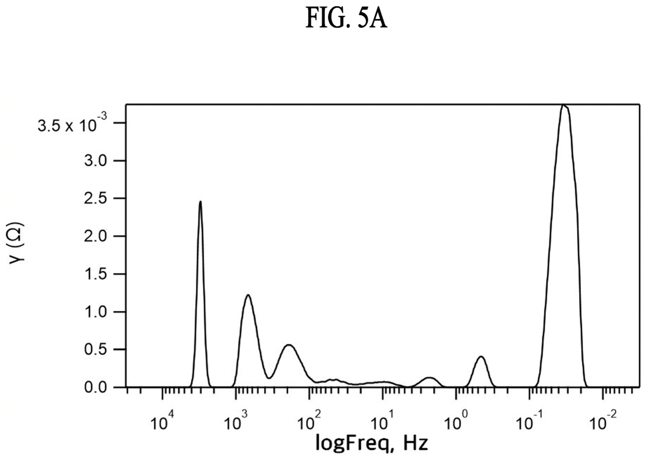

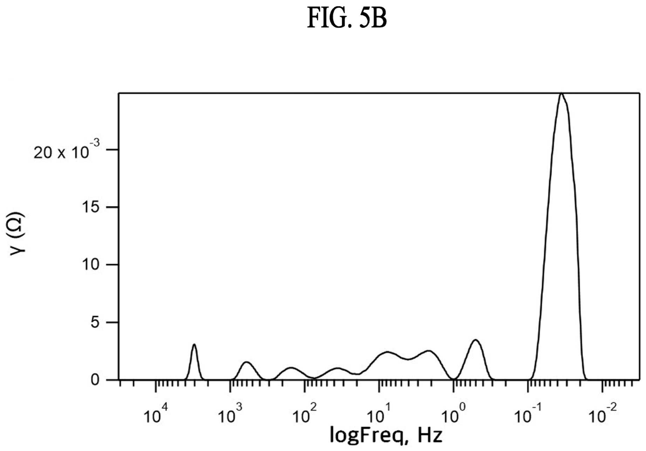

Meanwhile, a relationship, to DRT information, of a first portion 111 corresponding to a third state of charge in a charging process and a second portion 112 corresponding to a fourth state of charge in the charging process, which are illustrated in FIG. 4, will be described with reference to FIGS. 5A and 5B.

FIGS. 5A and 5B are diagrams for describing a relationship between a characteristic image and DRT information according to an example embodiment.

To begin with, FIG. 5A may illustrate a portion of DRT information corresponding to a third state of charge in a charging process. When FIG. 5A and the first portion 111 of FIG. 3 are compared, in portions corresponding to an equal frequency, a portion of FIG. 5A with a magnitude of impedance shown to be large may be identified as being darkly shown on the first portion 111 of FIG. 4. Similarly, FIG. 5B may illustrate a portion of DRT information corresponding to a fourth state of charge in the charging process. When FIG. 5B and the second portion 112 of FIG. 3 are compared, in portions corresponding to an equal frequency, a portion of FIG. 5B with a magnitude of impedance shown to be large may be identified as being darkly shown on the second portion 111 of FIG. 4.

According to an example embodiment, as identified by comparing FIGS. 5A and 5B and the first portion 111 and the second portion 112, the server 100 may generate a partial image for each state of charge by determining a degree of a shade with magnitude information for each frequency, which is indicated by the DRT information for each of a plurality of states of charge, and may generate a first characteristic image and a second characteristic image by sequentially stacking the partial image according to a value of a state of charge.

The characteristic image which is generated as such may include a unique pattern according to a characteristic of each battery cell. In other words, for example, generated characteristic images of battery cells of which materials of cathodes or anodes are different may be drawn to have patterns distinguishable from each other, and patterns of characteristic images of a battery cell used in a high-temperature environment and a low-temperature environment may be also different from each other. Also, patterns of characteristic images of battery cells having an identical characteristic may be drawn to be relatively similar. Since a characteristic of a battery cell may be estimated based on the characteristic image which has such a feature, a first example embodiment among example embodiments associated therewith will be described.

According to an example embodiment, the server 100 may generate a characteristic image of the battery cell 300 and then store the characteristic image of the battery cell 300, as at least a portion of a characteristic image set, in a database. In addition, the server 100 may perform a similar operation for a plurality of reference battery cells to generate a characteristic image for each of the reference battery cells and store the characteristic image for each of the reference battery cells, as a portion of the characteristic image set, in the database.

According to an example embodiment, each of images included in the characteristic image set may be stored in association with at least a portion of reference characteristic information including at least a portion of material information, degradation degree information, and utilization environment information on each of the reference battery cells which correspond to the respective images. That is, the server 100 may calculate a DRT based on a result of EIS of each of the reference battery cells which are categorized by reference characteristic information, generate characteristic images by using the DRT, and associate and store the characteristic images with the reference characteristic information for each of the reference battery cells. For example, a manager may prepare each of the reference battery cells which have respective characteristics and may generate characteristic images therefor to establish the characteristic image set.

An example in which the reference characteristic information includes the material information, the degradation degree information, and the utilization environment information has been described above. However, those skilled in the art may understand that the reference characteristic information may include various battery cell-associated characteristics that are not limited thereto.

According to an example embodiment, after such a characteristic image set is established, the sever 100 may estimate characteristic information on a target battery cell based on the characteristic image set. In other words, similarly to the above-described process, when a plurality of pieces of target EIS information is generated by performing the EIS at a plurality of states of charge different from each other of the target battery cell in a charging process or a discharging process, the server 100 may calculate target DRT information by acquiring the plurality of pieces of target EIS information and calculating a DRT. Afterward, the server 100 may generate a target image for the target battery cell based on the target DRT information. The server 100 may estimate the characteristic information on the target battery cell based on the target image and the characteristic image set generated as such.

Specifically, the server 100 may calculate similarities between the target image and the images included in the characteristic image set. Afterward, reference characteristic information associated with an image having a highest similarity may be estimated to be the characteristic information on the target battery cell. As described above, since the battery cell has the unique characteristic image according to the characteristic thereof, the target battery cell may be estimated to have a characteristic similar to that of a reference battery cell corresponding to the image having the highest similarity among the images included in the characteristic image set.

As a modified example embodiment of the above-described example embodiment of estimating the characteristic information on the target battery cell based on the similarity to the images included in the characteristic image set, an example embodiment of using an artificial neural network will be described. In other words, according to an example embodiment, the server 100 may be mounted with an artificial neural network trained based on the characteristic image set and use the artificial neural network to estimate the characteristic information of the target battery cell. The artificial neural network may be trained by using, as learning data and ground-truth, the characteristic image set and the reference characteristic information which is associated with each image included therein. The artificial neural network may be implemented through various schemes used for a widely known convolutional neural network (CNN) or image processing. When the artificial neural network is implemented by the CNN, the artificial neural network may generate output information for leaning by calculating each image included in the characteristic image set as the learning data, generate a loss by comparing the output information for learning and the reference characteristic information as the ground-truth, and then learn at least a portion of self-included parameters by reversely propagating the loss. The artificial neural network trained as such may calculate the target image and then output characteristic information that the target battery cell is estimated to have.

Next, a second example embodiment of estimating the characteristic of the battery cell based on the characteristic image will be described.

According to an example embodiment, the server 100 may estimate at least a portion of characteristic information on the battery cell 300 by performing an analysis based on the characteristic image. The characteristic information may include at least a portion of material information, degradation degree information, and utilization environment information on the battery cell 300. Hereinafter, respective examples of estimating the material information, the degradation degree information, and the utilization environment information.

To begin with, the server 100 may determine symmetry, with a maximum SoC as a reference, between the first characteristic image which corresponds to a charging process of the battery cell 300 and the second characteristic image which corresponds to a discharging process of the battery cell 300, which are included in the characteristic image. Here, the symmetry may be determined based on a similarity at a time of comparing the first characteristic image and the second characteristic image on an equal scale in terms of a state of charge and a frequency. That is, first axes of the first characteristic image and the second characteristic image may be regarded as a logarithmically scaled frequency, second axes thereof may be regarded the state of charge. The second axes may be equally scaled with first points of the second axes as a SoC 0% state and second points of the second axes as a SoC 100% state, and then the similarity between the first characteristic image and the second characteristic image may be calculated. When the similarity is greater than or equal to a threshold, the server 100 may determine that the symmetry is present between the first characteristic image and the second characteristic image. When the similarity is less than the threshold, the server 100 may determined that the symmetry is absent between the first characteristic image and the second characteristic image. Here, the similarity may correspond to a similarity between the first characteristic image and the second characteristic image for a charging process and a discharging process of a lithium-ion battery totally not including silicon oxide in an anode. Such a similarity between images may be calculated by applying known exiting various algorithms. For example, shade values at respective coordinates of the first characteristic image and the second characteristic image may be compared to calculate a difference value for each coordinate, and the similarity may be calculated so as to be in inverse proportion to a sum of difference values for all coordinates.

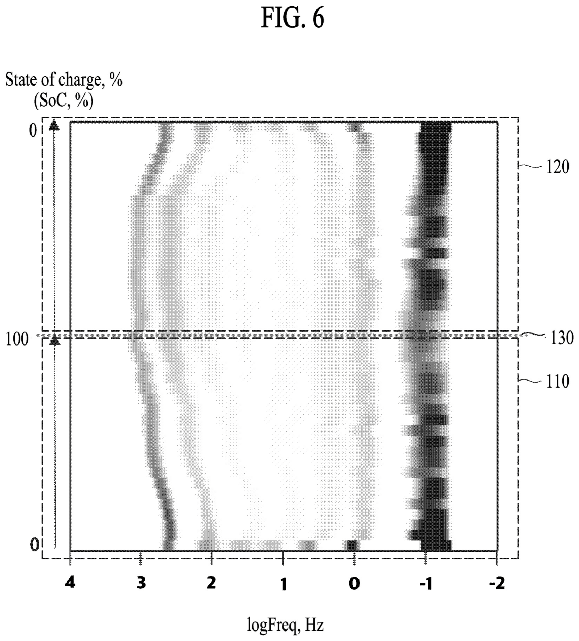

At this point, when the symmetry is present, the server 100 may determine that the battery cell 300 does not include silicon oxide in an anode. When the silicon oxide is included in the anode of the lithium-ion battery, hysteresis may occur in an electrode state in a charging process and a discharging process due to a distinguishing reaction of the silicon oxide in the anode. Thus, when the silicon oxide is included in the anode, the first characteristic image and the second characteristic image for the charging process and the discharging process, respectively, may differ. When the silicon oxide is not included in the anode, the first characteristic image and the second characteristic image may be identical because the hysteresis does not occur. With such a feature, whether the anode includes the silicon oxide may be determined based on the characteristic image. FIGS. 4 and 6 described above will be newly referenced in order to check such an example embodiment.

Referring back to FIG. 4 described above, the the first characteristic image 110 and the second characteristic image 120 may be identified as being symmetrical around the reference axis 130. The above-described calculation of the similarity may be performed after one of the first characteristic image 110 and the second characteristic image 120 is vertically reversed around the reference axis 130. When the one is vertically reversed around the reference axis 130, since shade degrees of corresponding coordinates of the first characteristic image 110 and the second characteristic image 120 show an impedance magnitude for an equal state of charge and an equal frequency, it may be considered that the first characteristic image 110 and the second characteristic image 120 are adjusted to be on an identical scale as described above so that the similarity is calculated. As illustrated in FIG. 4, when the first characteristic image 110 and the second characteristic image 120 are symmetrical, the server 100 may determine that the battery cell 300 does not include the silicon oxide in the anode. In addition, referring to FIG. 4, the symmetry which is described in the present disclosure may be understood as symmetry of the first characteristic image 110 and the second characteristic image 120 around the reference axis 130.

FIG. 6 is an example diagram illustrating a characteristic image corresponding to a battery cell including silicon oxide in an anode according to an example embodiment.

FIG. 6 is the example diagram illustrating the characteristic image corresponding to the battery cell including the silicon oxide in the anode, and the first characteristic image 110 and the second characteristic image 120 may be identified as being asymmetrical around the reference axis 130. As described above, when the silicon oxide is included in the anode, since a charging process and a discharging process are not symmetrical due to hysteresis, as such, in a characteristic image, the first characteristic image 110 and the second characteristic image 120 may be drawn to be asymmetrical around the reference axis 130. As illustrated in FIG. 6, when the first characteristic image 110 and the second characteristic image 120 are determined to be asymmetrical, the server 100 may determine that the battery cell 300 includes silicon oxide in an anode.

According to an example embodiment, the server 100 may estimate a ratio of the silicon oxide included in the anode based on a similarity. When an amount of the silicon oxide included in the anode becomes large, the hysteresis may occur on a large scale, and thus, the charging process and the discharging process may be further asymmetrical. When the charging process and the discharging process become further asymmetrical, a similarity between the first characteristic image and the second characteristic image may be calculated to be low. Accordingly, the server 100 may estimate the ratio of the included silicon oxide to be in inverse proportion to the similarity.

The above-described example embodiment may be applied to a case in which another compound including silicon other than silicon oxide, for example, silicon carbide, silicon nitride, or a silicon alloy is included in the anode. Alternatively, the above-described example embodiment may be applied to a case in which a component inducing the hysteresis is included in the anode, a cathode, or an electrolyte.

Meanwhile, according to an example embodiment, the server100 may extract a shape pattern according to a shade on the characteristic image by calculating the characteristic image. Afterward, the server 100 may estimate at least a portion of utilization environment information on the battery cell 300 based on the shape pattern. As an example, a battery cell continuously used at a high temperature or a low temperature may accordingly have a distinguishing shape pattern on a characteristic image, for example, a straight line shape appears at a predetermined frequency or a curved line sloping upward or downward on a right side. Alternatively, in a case of frequent quick charging, or when charging and discharging alternate at intervals of a short time due to regenerative braking in a state in which a battery cell is mounted to a car or the like, a distinguishing shape pattern may exist. The server 100 may estimate the at least a portion of the utilization environment information on the battery cell 300 based on such a shape pattern. In addition thereto, according to an example embodiment, at least a portion of material information on the battery cell 300 may be estimated based on the shape pattern. For example, when the shape pattern shown on the characteristic image is compared to a shape pattern distinguishingly shown for a predetermined material included in the cathode or another predetermined material included in the electrolyte and is similar thereto, the server 100 may estimate that the predetermined materials are included in the cathode or the electrolyte.

Also, according to an example embodiment, the server100 may acquire shade amount information on the characteristic image by calculating the characteristic image. Afterward, the server 100 may estimate degradation degree information on the battery cell 300 based on the shade amount information. When the battery cell 300 is used for a long time and has a high degradation degree, inner resistance is increased. When the inner resistance is increased, a magnitude of impedance is increased, and accordingly, a shade of a coordinate of the above-described characteristic image is darkly shown. Thus, in a case of the battery cell 300 which is used for the long time, an amount of entire shades on the characteristic image may be regarded as being larger than that of a battery cell that is used less. Accordingly, the server 100 may estimate, based on the shade amount information, the degradation degree information so that the amount of the shades and a degradation degree are in proportion to each other. Characteristic information on a target battery cell may be estimated accurately and in a non-destructive manner through the above-described scheme.

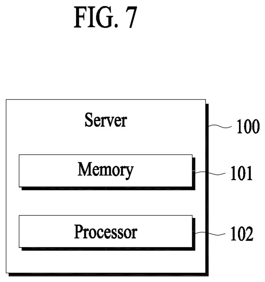

FIG. 7 is a block diagram illustrating a server according to an example embodiment.

According to an example embodiment, the server 100 may include a memory 101 and a processor 102. In the server 100 which is illustrated in FIG. 7, only elements associated with the present example embodiment are illustrated. Thus, those skilled in the art associated with the present example embodiment may understand that other elements in general use in addition to the elements illustrated in FIG. 7 may be further included. In an example embodiment, the processor 102 may be included in a controller.

The processor 102 may control overall operations of the server 100 and process data and a signal. The processor 102 may be formed of at least one hardware unit. In addition, the processor 102 may be operated by one or more software module generated by executing program code stored in the memory 101. Since the processor 102 may include a memory, the processor 102 may control the overall operations of the server 100 and process the data and the signal by executing program code stored in the memory.

The processor 102 may acquire electrochemical impedance spectroscopy (EIS) information for each of a plurality of states of charge different from each other, which is identified by performing electrochemical impedance spectroscopy for a battery cell at the plurality of states of charge, generate distribution of relaxation times (DRT) information for each of the plurality of states of charge by calculating a distribution of relaxation times for the EIS information for each of the plurality of states of charge, and generate, based on the DRT information for each of the plurality of states of charge, a characteristic image that corresponds to the battery cell and includes magnitude information on impedance according to a frequency, which is calculated for each of the plurality of states of charge.

Depending on example embodiments, the server 100 may additionally include a transceiver for performing wired/wireless communication. The server 100 may communicate with an external electronic device (e.g., the battery management device 200) by using the transceiver. The external electronic device may be a terminal or a server. Also, a communication technology used by the transceiver may include Global System for Mobile communication (GSM), Code Division Multi Access (CDMA), Long Term Evolution (LTE), 5th Generation, (5G), a wireless local area network (WLAN), Wireless-Fidelity (Wi-Fi), Bluetooth, radio frequency identification (RFID), infrared data association (IrDA), ZigBee, near field communication (NFC), or the like.

The apparatus according to the above-described example embodiments may include a processor, a memory that stores and executes program data, a permanent storage such as a disk drive, a communication port for communicating with an external device, and a user interface device such as a touch panel, a key, and an button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor.

The above-described embodiments are merely examples and other embodiments may be implemented within the scope of the following claims.

## Claims

1. A battery analysis method performed in a server, the battery analysis method comprising:
acquiring electrochemical impedance spectroscopy (EIS) information for each of a plurality of states of charge, which is identified by performing electrochemical impedance spectroscopy for a battery cell at the plurality of states of charge that are different from each other;
generating distribution of relaxation times (DRT) information for each of the plurality of states of charge by calculating a distribution of relaxation times for the EIS information for each of the plurality of states of charge; and
generating, based on the DRT information for each of the plurality of states of charge, a characteristic image that corresponds to the battery cell and includes magnitude information on impedance according to a frequency, which is calculated for each of the plurality of states of charge.

2. The battery analysis method of claim 1, wherein the generating of the characteristic image comprises generating, based on the DRT information for each of the plurality of states of charge, the characteristic image that has a form of a two-dimensional image of which a first axis is the frequency, a second axis is the plurality of states of charge, and a shade degree of each pixel is determined based on the magnitude information on the impedance that is calculated for each of the frequency and the plurality of states of charge.

3. The battery analysis method of claim 2, wherein the generating of the characteristic image comprises:
generating a first characteristic image for a charging process of the battery cell, which is at least a portion of the characteristic image, based on first magnitude information on the impedance according to the frequency for each of the plurality of states of charge for the charging process, and identifying the first magnitude information based on first DRT information for each of the plurality of states of charge in the charging process; and
generating a second characteristic image for a discharging process of the battery cell, which at least a portion of the characteristic image, based on second magnitude information on the impedance according to the frequency for each of the plurality of states of charge for the discharging process, and identifying the second magnitude information based on second DRT information for each of the plurality of states of charge in the discharging process.

4. The battery analysis method of claim 3, wherein the characteristic image includes the first characteristic image and the second characteristic image so that the first characteristic image and the second characteristic image are symmetrical around a reference axis parallel to the first axis.

5. The battery analysis method of claim 1, further comprising storing a characteristic image set for a plurality of reference battery cells, which includes the characteristic image.

6. The battery analysis method of claim 5, wherein the characteristic image set is stored in association with at least a portion of reference characteristic information including at least a portion of material information, degradation degree information, and utilization environment information on each of the reference battery cells that correspond to respective images included in the character image set.

7. The battery analysis method of claim 5, further comprising:
generating a target image for a target battery cell based on target DRT information, and acquiring the target DRT information by calculating the DRT for target EIS information, after acquiring a plurality of pieces of target EIS information by performing the EIS at a plurality of states of charge different from each other of the target battery cell; and
estimating characteristic information on the target battery cell based on the characteristic image set and the target image.

8. The battery analysis method of claim 7, wherein the estimating of the characteristic information on the target battery cell comprises estimating, after calculating similarities between the target image and images included in the characteristic image set, reference characteristic information associated with an image having a highest similarity among the similarities to be the characteristic information on the target battery cell.

9. The battery analysis method of claim 7, wherein the estimating of the characteristic information on the target battery cell comprises estimating, by inputting the target image to an artificial neural network trained by receiving the characteristic image set and reference characteristic information corresponding to each image included in the characteristic image set as learning data and ground-truth for the learning data, characteristic information that is output as the artificial neural network processes the target image to be the characteristic information on the target battery cell.

10. The battery analysis method of claim 1, wherein the acquiring of the electrochemical impedance spectroscopy (EIS) information for each of the plurality of states of charge comprises:
acquiring first EIS information that is at least a portion of the EIS information, which is a result of the EIS being performed for the battery cell by a battery management device each time a state of charge of the battery cell is increased by a predetermined interval in a charging process that allows the battery cell at a first state of charge to be at a second state of charge higher than the first state of charge; and
acquiring second EIS information that is at least a portion of the EIS information, which is a result of the EIS being performed for the battery cell by the battery management device each time the state of charge of the battery cell is decreased by a predetermined interval in a discharging process that allows the battery cell at the second state of charge to be at the first state of charge.

11. The battery analysis method of claim 1, wherein the generating of the DRT information comprises:
generating first DRT information for each of the plurality of states for a charging process of the battery cell, which is at least a portion of the DRT information, by calculating the DRT for first EIS information for each of the plurality of states of charge in the charging process; and
generating second DRT information for each of the plurality of states for a discharging process of the battery cell, which is at least a portion of the DRT information, by calculating the DRT for second EIS information for each of the plurality of states of charge in the discharging process.

12. The battery analysis method of claim 1, further comprising estimating at least a portion of characteristic information including at least a portion of material information, degradation degree information, and utilization environment information on the battery cell by performing an analysis based on the characteristic image.

13. The battery analysis method of claim 12, wherein the estimating of the at least a portion of the characteristic information comprises:
determining symmetry between a first characteristic image corresponding to a charging process of the battery cell and a second characteristic image corresponding to a discharging process of the battery cell that are included the characteristic image; and
estimating at least a portion of the material information on the battery cell based on the symmetry.

14. The battery analysis method of claim 12, wherein the determining of the symmetry comprises
calculating a similarity between the first characteristic image and the second characteristic image; and
determining, based on the similarity being less than a threshold, that the symmetry between the first characteristic image and the second characteristic image is absent.

15. The battery analysis method of claim 12, wherein the estimating of the at least a portion of the material information on the battery cell comprises determining, based on the first characteristic image and the second characteristic image not having the symmetry, that at least a portion of an anode of the battery cell includes silicon oxide.

16. The battery analysis method of claim 12, wherein the estimating of the at least a portion of the material information on the battery cell comprises estimating a ratio of the included silicon oxide to be in inverse proportion to a similarity between the first characteristic image and the second characteristic image, which corresponds to the symmetry.

17. The battery analysis method of claim 12, wherein the estimating of the at least a portion of the characteristic information on the battery cell comprises:
extracting a shape pattern according to a shade on the characteristic image by calculating the characteristic image; and
estimating at least a portion of the utilization environment information on the battery cell based on the shape pattern.

18. The battery analysis method of claim 12, wherein the estimating of the at least a portion of the characteristic information on the battery cell comprises:
acquiring shade amount information on the characteristic image by calculating the characteristic image; and
estimating the degradation degree information on battery cell based on the shade amount information.

19. A non-transitory computer-readable recording medium in which a program for executing the method of claim 1 to 18 in a server is recorded.

20. A sever comprising:
a memory configured to store an instruction; and
a processor connected to the memory,
wherein the processor is configured to:
acquire electrochemical impedance spectroscopy (EIS) information for each of a plurality of states of charge, which is identified by performing electrochemical impedance spectroscopy for a battery cell at the plurality of states of charge that are different from each other;
generate distribution of relaxation times (DRT) information for each of the plurality of states of charge by calculating a distribution of relaxation times for the EIS information for each of the plurality of states of charge; and
generate, based on the DRT information for each of the plurality of states of charge, a characteristic image that corresponds to the battery cell and includes magnitude information on impedance according to a frequency, which is calculated for each of the plurality of states of charge.
